# EUROPEAN PATENT APPLICATION

(11) **EP 4 654 409 A1**
(43) Date of publication of application: **26.11.2025**
(21) Application number: 24177526.1
(22) Date of filing: 23.05.2024
(51) Int. Cl.: H02H 3/087

(54) **POWER SYSTEM WITH CURRENT SENSORS FOR FAULT DETECTION**

(71) Applicant: ABB SCHWEIZ AG, 5400 Baden (CH)
(72) Inventor: SCHAEFFER, David, Västerås (SE); MAGNUSSON, Jesper, Åkersberga (SE); KANCHAN, Rahul, Västerås (SE); NIEMI, Mika, Helsinki (FI); OINONEN, Markus, Helsinki (FI)
(74) Representative: Kransell & Wennborg KB

(57) **Abstract**

Power system (1) comprising: a DC bus (3), a plurality of power modules (5), each comprising a capacitor, each power module (5) being connected to the DC bus (3) in parallel with the other power modules (5), a plurality of arc suppressing devices (11) configured to short circuit the DC bus (3) in case of a fault on the DC bus (3), a plurality of current sensors (13), each being arranged to measure current between the DC bus (3) and a DC side of a respective power module (5), and a control system associating each current sensor (13) with an arc suppressing device (11) of the plurality of arc suppressing devices (11), wherein the control system is configured to, only when at least two of the current sensors (13) simultaneously measure a current higher than a threshold current, trigger the arc suppressing device (11) or arc suppressing devices (11) associated with the at least two current sensors (13) to short circuit the DC bus (3).

## Description

### TECHNICAL FIELD

The present disclosure generally relates to power systems such as electric drive systems.

### BACKGROUND

An electric drive is a system comprising power converters, typically inverters, and a control system that controls the inverters. Electric drive systems can for example be used to control a plurality of electric motors in an industrial setting such as in pulp and paper manufacturing or in metal manufacturing, in a marine vessel, for integration of battery or fuel cell energy storage systems, and active front-end converters for bidirectional energy flow into and out of an AC grid.

In more detail, a drive system may comprise a DC bus to which the multiple power converters are connected in parallel. In case of an internal arc fault on the DC bus, the capacitor banks of the power converters/power modules are due to their parallel connection quickly discharged into the arc. Since typically there are many power converters in a drive system, for example in the order of 50, capacitor discharging causes massive destruction of the installation. Today, the cabinets in which the power converters are housed are built to sustain a pressure increase resulting from the internal arc. The cabinets are thus over dimensioned to withstand the explosion, preventing the cabinets from opening. In the event that an internal arc fault occurs, it may in some cases take months to repair or replace the damaged equipment.

To limit damages to the drive system caused due to an arc fault on the DC bus, a drive system may comprise controllable arc suppressing devices for short-circuiting the DC bus locally, close to the arc.

### SUMMARY

One way to detect faults in a drive system is by light detection of the generated arc to trigger one or more arc suppressing devices to locally short circuit the DC bus. However, light detection has proved to be too efficient, and provides no selectivity at all in fault detection. For example, when an internal fault occurs in a power module due to the high currents involved, it is likely that an arc is generated. The light from the arc is reflected on the inner walls inside the cabinet in which the power module is arranged. The light is likely detected by a light detector, triggering an arc suppressing device. Since power module faults are more frequent than DC bus faults, and since there is a very high likelihood to detect any fault with a resulting light using light detectors, the drive system will be subjected to more downtime than would be desirable. Moreover, faults on the power module can be handled by the DC fuses, leaving the overall system running.

In view of the above, the present inventors have found that fault detection should be more selective to trigger the arc suppressing devices only in case of a fault on the DC bus and not in case of faults at the power module level. This would maximise the time that the drive system is running.

An object of the present disclosure is therefore to provide a power system which solves or at least mitigates the problems of the prior art.

There is hence according to a first aspect of the present disclosure provided a power system comprising: a DC bus, a plurality of power modules, each comprising a capacitor or a battery, each power module being connected to the DC bus in parallel with the other power modules, a plurality of arc suppressing devices configured to short circuit the DC bus in case of a fault on the DC bus, a plurality of current sensors, each being arranged to measure current between the DC bus and a DC side of a respective power module, and a control system associating each current sensor with an arc suppressing device of the plurality of arc suppressing devices, wherein the control system is configured to, only when at least two of the current sensors simultaneously measure a current higher than a threshold current, trigger the arc suppressing device or arc suppressing devices associated with the at least two current sensors to short circuit the DC bus.

The fault detection is faster than previous methods relying on light detection from the arc, is selective because the location of the fault is known from the current sensors, and safer against false triggering events because of the requirement that at least two current sensors need to measure a current higher than the threshold current simultaneously.

The fault on the DC bus may be an arcing fault.

The power system may for example be a low voltage or a medium voltage power system.

Triggering an arc suppressing device may involve setting the arc suppressing device in an on-state.

According to one embodiment at least two of said at least two current sensors are arranged to measure current between the DC bus and a respective one of two adjacently located power modules. The two adjacently located power modules are thus located adjacently along the DC bus. The risk of false triggering events can thereby be reduced further, because if two adjacent current sensors measure a current higher than the threshold current simultaneously, it can be determined with greater probability that the measured high currents are due to a fault on the DC bus and not because of a fault in e.g. one of the power modules.

According to one embodiment the control system is configured to trigger the arc suppressing device or arc suppressing devices only when, additionally, a current flow direction of the measured currents is from the power modules into the DC bus. This indicates that current is flowing from the power module, i.e., from a capacitor bank, and not from the DC bus to the power module, which gives a further indication that the fault is on the DC bus and not in a power module.

According to one embodiment the current sensors are arranged to measure current flowing between a positive busbar of the DC bus and the respective power module. Since the current flow direction is from the positive busbar to a negative busbar, this provides an indication that the fault is on the DC bus and not in the power module.

The current sensors could alternatively be arranged to measure current flowing between the negative busbar and the respective power module.

According to one example at least some of the power modules are power converters.

According to one embodiment at least some of the power modules are power converters.

According to one example each power module is one of an inverter, a DC/DC converter, a line side active and/or passive rectifier, a DC/DC chopper, and/or a braker chopper.

According to one embodiment the control system is configured to compare the current measured by the current sensors with the threshold current.

According to one embodiment the control system comprises a plurality of controllers, each being configured to control a power module or a group of power modules, and each being associated with one or more current sensors and configured to trigger the associated arc suppressing device or arc suppressing devices.

According to one embodiment the power system is a multi-drive system. The DC bus is a common DC bus for all the power modules.

There is according to a second aspect provided a method of triggering arc suppressing devices in a power system comprising a DC bus, a plurality of power modules, each comprising a capacitor, each power module being connected to the DC bus in parallel with the other power modules, a plurality of arc suppressing devices configured to short circuit the DC bus in case of a fault on the DC bus, a plurality of current sensors, each being arranged to measure current between the DC bus and a DC side of a respective power module, and a control system associating each current sensor with an arc suppressing device of the plurality of arc suppressing devices, the method comprising: a) only when at least two of the current sensors simultaneously measure a current higher than a threshold current, triggering, by means of the control system, the arc suppressing device or arc suppressing devices associated with the at least two current sensors to short circuit the DC bus.

One embodiment comprises, prior to step a) comparing the current measured by the current sensors with the threshold current.

According to one embodiment at least two of said at least two current sensors are arranged to measure current between the DC bus and a respective one of the two adjacently located power modules.

According to one embodiment the triggering is performed only when, additionally, a current flow direction of the measured currents is from the power modules to the DC bus.

According to one embodiment the current sensors measure current flowing between a positive busbar of the DC bus and the respective power module.

According to one embodiment at least some of the power modules are inverters.

Generally, all terms used in the claims are to be interpreted according to their ordinary meaning in the technical field, unless explicitly defined otherwise herein. All references to "a/an/the element, apparatus, component, means", etc. are to be interpreted openly as referring to at least one instance of the element, apparatus, component, means, etc., unless explicitly stated otherwise.

### BRIEF DESCRIPTION OF THE DRAWINGS

The specific embodiments will now be described, by way of example, with reference to the accompanying drawings, in which:
Fig. 1 schematically shows an example of a power system;
Fig. 2 schematically shows a power module connected to a DC bus; and
Fig. 3 schematically shows the power system in Fig. 1 in the event of a DC bus fault.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

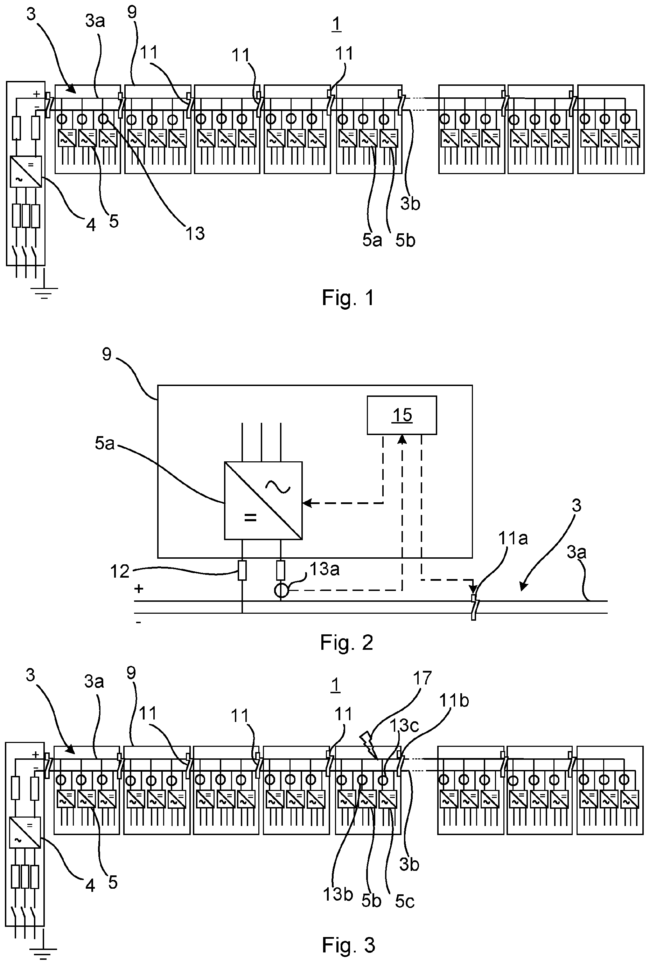

Fig. 1 is a circuit diagram of one example of a power system 1. The power system 1 may for example be a drive system such as a multi-drive system.

The power system 1 comprises a DC bus 3.

According to the example the DC bus 3 comprises a first busbar 3a and a second busbar 3b.

The DC bus 3 may be a low voltage or a medium voltage DC bus.

The DC bus 3 is connected to a rectifier 4. The rectifier 4 may be connected to an AC power network, such as a three-phase power network.

The power system 1 comprises a plurality of power modules 5. Each power module 5 comprises a capacitor or a capacitor bank, and/or a battery.

The power modules 5 may for example be power converters such as inverters.

The power modules 5 are connected to the DC bus 3. Each power module 5 is connected to the first busbar 3a and to the second busbar 3b. Each power module 5 may have a DC side and an AC side. The DC side is connected to the DC bus 3. The AC side is configured to be, or is, connected to an AC load such as an electric motor, or a power transformer, a power source such as an AC grid supply, or an AC generator. The power module 5 may according to one example have two DC sides, with one DC side connected to the DC bus and the other DC side connected to a brake chopper, or a DC/DC converter connected to an energy storage like a battery or fuel cells.

The power modules 5 are connected to the DC bus 3 in parallel with each other.

The power system 1 comprises a plurality of cabinets 9. Each cabinet 9 comprises one or more power modules 5 arranged inside the cabinet 9.

The cabinets 9 are, when the power system 1 has been installed, typically arranged in a chain, one after the other. The physical length of the DC bus 3 typically depends on the number of cabinets 9.

According to the example, each cabinet 9 comprises three power modules 5, but there could be other number of power modules 5 per cabinet. There could for example be one, two, or four power modules 5 per cabinet. All the cabinets 9 may have the same number of power modules 5, or the number of power modules 5 could be different in some or all of the cabinets 9.

The power system 1 comprises a control system. The control system may be configured to control all the power modules 5. In some examples, the control system comprises a plurality of controllers, each configured to control a respective power module 5, or a group of power modules 5. For example, each or some of the controllers may be configured to control all the power modules 5 arranged in a cabinet 9.

The power system 1 comprises a plurality of arc suppressing devices 11. The arc suppressing devices 11 are connected to the DC bus 3. The arc suppressing devices 11 may be connected across the first busbar 3a and the second busbar 3b. Each arc suppressing device 11 is configured to short circuit the DC bus 3 by short-circuiting the first busbar 3a and the second busbar 3b. The arc suppressing devices 11 are configured to short-circuit the DC bus 3 in response to a fault on the DC bus 3 as will be described in more detail herein.

The arc suppressing devices 11 have a lower voltage drop over the first busbar 3a and the second busbar 3b than the arc voltage of an electric arc on the DC bus 3.

Each arc suppressing device 11 may comprise one or more switching devices. The switching device may have a first leg connected to the first busbar 3a and a second leg connected to the second busbar 3b. In case of a plurality of switching devices, the switching devices may be connected in parallel across the first busbar 3a and the second busbar 3b. The switching devices may for example be semiconducting devices.

In case the switching devices are semiconducting devices, by turning the semiconducting device(s) to an on-state, the first busbar 3a and the second busbar 3b are connected via the semiconducting device or devices, which are thus short-circuited.

Each semiconducting device may for example be a thyristor or a transistor such as an insulated gate bipolar transistor (IGBT) or an insulated gate-commutated transistor (IGCT).

Each arc suppressing device 11 is assigned to K power module 5, where K may be an integer equal to or greater than 1. K may for example be 2, 3, 4, 5, 6, 7, 8 or 9. According to the example in Fig. 1, each arc suppressing device 11 is assigned to three power modules 5. Thus, in this example, K=3.

The arc suppressing devices 11 may for example be arranged between adjacent power modules 5 or between adjacent cabinets 9.

The power system 1 comprises a plurality of current sensors 13. The power system 1 may for example comprise as many current sensors 13 as there are power modules 5. For example, if the power system 1 comprises N power modules 5, the power system 1 may comprise N current sensors 13. Each current sensor 13 is configured to measure current between the DC bus 3 and a respective power module 5.

Each current sensor 13 may be arranged to measure current flowing between a positive busbar, in the present example the first busbar 3a, of the DC bus 3 and the respective power module 5. The current sensors 13 may thus measure current flow from the respective power module 5 to the positive busbar.

The current sensors 13 are configured to communicate current measurements to the control system.

The control system associates each current sensor 13 with an arc suppressing device 11 of the plurality of arc suppressing devices 11. According to one example, a plurality of current sensors 13 may be associated with the same arc suppressing device 11 and/or one or more current sensors 13 may be associated with more than one arc suppressing devices 11. In one example, each controller may associate the current sensor 13 or current sensors 13 which are configured to measure currents between the power module(s) 5 that the controller is configured to control and the DC bus 3 with one or more of the arc suppressing devices 11 of the power system 1.

Fig. 2 schematically shows of a portion of the power system 1, with a single power module 5a illustrated in the cabinet 9.

The controller 15 may control a single power module 5a or more than one power module 5, such as all the power modules 5 arranged in the cabinet 9.

The current sensor 13a is configured to measure current flow from the power module 5a to the positive busbar, i.e., the first busbar 3a of the DC bus 3.

The controller 15 is arranged to receive measurements of current from the current sensor 13a which is arranged to measure the current from the power module 5a to the first DC bus 3a.

The controller 15 is configured to control the arc suppressing device 11a associated with the power module 5a based on the measured current from the current sensor 13a. The controller 15 is configured to, only when at least two of the current sensors 13, including the current sensor 13a, simultaneously measure a current higher than a threshold current, trigger the arc suppressing device 11a or arc suppressing devices 11 associated with these current sensors 13a, 13 to short circuit the DC bus 3.

Preferably, triggering of an arc suppressing device 11 is only performed by the controller 15 if at least two current sensors 13 of two adjacently located power modules 5 measure a current higher than the threshold current simultaneously. Controllers 15 may be configured to communicate with each other, such that in case current sensors 13 of adjacently located power modules 5 controlled by different controllers 15 measure a current higher than the threshold current, at least all concerned controllers 15 receive information that currents higher than the threshold current have been measured. In another example, the controllers 15 are independent, i.e., the controllers 15 are not configured to communicate with each other.

It is to be noted that triggering will also occur if the current sensors 13 of more than two adjacently located power modules 5 measure a current higher than the threshold current, e.g., if the current sensors 13 of any of three, four, five,..., M where M is the number of power modules 5 of the power system 1, power modules 5 located in a row one after the other measure a current higher than the threshold current.

The controller 15 is configured to trigger the arc suppressing device 11a or arc suppressing devices 11 only when in addition to the measured current being higher than the threshold current, a current flow direction of the measured currents is from the power module 5a to the DC bus 3.

The power system 1 may comprise fuses 12 arranged on the DC side of the power modules 5 and connected to the DC bus 3. The fuses 12 are triggered in case of an internal fault in a power module 5. The power system 1 remains in operation thanks to the selectivity of the fuses 12.

Fig. 3 shows an example of operation of the power system 1 in the event of an arcing fault on the DC bus 3. According to the example, an arcing fault resulting in an electric arc 17 on the DC bus 3 occurs in a region of the DC bus 3 where the power modules 5b and 5c are connected to the DC bus 3.

The current sensors 13b-13c that are configured to measure current in a region of the power modules 5b and 5c will measure currents flowing to the DC bus 3, which are higher than the threshold current, and the controller or controllers 15 arranged to control the power modules 5b and 5c compares the measured currents with the threshold current. As a result, the controller 15 will trigger the arc suppressing device 11b to short circuit the DC bus 3 close to the electric arc 17. The current is therefore commutated from the electric arc 17.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. Power system (1) comprising:
a DC bus (3),
a plurality of power modules (5), each comprising a capacitor or a battery, each power module (5) being connected to the DC bus (3) in parallel with the other power modules (5),
a plurality of arc suppressing devices (11) configured to short circuit the DC bus (3) in case of a fault on the DC bus (3),
a plurality of current sensors (13), each being arranged to measure current between the DC bus (3) and a DC side of a respective power module (5), and
a control system associating each current sensor (13) with an arc suppressing device (11) of the plurality of arc suppressing devices (11),
wherein the control system is configured to, only when at least two of the current sensors (13) simultaneously measure a current higher than a threshold current, trigger the arc suppressing device (11) or arc suppressing devices (11) associated with the at least two current sensors (13) to short circuit the DC bus (3).

2. Power system (1) as claimed in claim 1, wherein at least two of said at least two current sensors (13) are arranged to measure current between the DC bus (3) and a respective one of two adjacently located power modules (5).

3. Power system (1) as claimed in claim 1 or 2, wherein the control system is configured to trigger the arc suppressing device (11) or arc suppressing devices (11) only when, additionally, a current flow direction of the measured currents is from the power modules (5) into the DC bus (3).

4. Power system (1) as claimed in claim 3, wherein the current sensors (13) are arranged to measure current flowing between a positive busbar of the DC bus (3) and the respective power module (5).

5. Power system (1) as claimed in any of the preceding claims, wherein at least some of the power modules (5) are power converters.

6. Power system (1) as claimed in any of the preceding claims, wherein the control system is configured to compare the currents measured by the current sensors (13) with the threshold current.

7. Power system (1) as claimed in any of the preceding claims, wherein the control system comprises a plurality of controllers (15), each being configured to control a power module (5) or a group of power modules (5), and each being associated with one or more current sensors (13) and configured to trigger the associated arc suppressing device (11) or arc suppressing devices (11).

8. Power system (1) as claimed in any of the preceding claims, wherein the power system (1) is a multi-drive system.

9. Method of triggering arc suppressing devices (11) in a power system (1) comprising a DC bus (3), a plurality of power modules (5), each comprising a capacitor, each power module (5) being connected to the DC bus (3) in parallel with the other power modules (5), a plurality of arc suppressing devices (11) configured to short circuit the DC bus (3) in case of a fault on the DC bus (3), a plurality of current sensors (13), each being arranged to measure current between the DC bus (3) and a DC side of a respective power module (5), and a control system associating each current sensor (13) with an arc suppressing device (11) of the plurality of arc suppressing devices (11), the method comprising:
a) only when at least two of the current sensors (13) simultaneously measure a current higher than a threshold current, triggering, by means of the control system, the arc suppressing device (11) or arc suppressing devices (11) associated with the at least two current sensors (13) to short circuit the DC bus.

10. Method as claimed in claim 9, comprising prior to step a) comparing the currents measured by the current sensors (13) with the threshold current.

11. Method as claimed in claim 9 or 10, wherein at least two of said at least two current sensors (13) are arranged to measure current between the DC bus and a respective one of two adjacently located power modules (5).

12. Method as claimed in any of claims 9-11, wherein the triggering is performed only when, additionally, a current flow direction of the measured currents is from the power modules (5) to the DC bus (3).

13. Method as claimed in claim 12, wherein the current sensors (13) measure current flowing between a positive busbar of the DC bus (3) and the respective power module (5).

14. Method as claimed in any of claims 9-13, wherein at least some of the power modules (5) are power converters.
